# EUROPEAN PATENT APPLICATION

(11) **EP 4 797 326 A1**
(43) Date of publication of application: **26.08.2026**
(21) Application number: 25159231.7
(22) Date of filing: 20.02.2025
(51) Int. Cl.: H01L 21/768, H01L 21/033, H01L 21/311, G06F 30/392, H10D 84/90, H10D 89/10

(54) **A PATTERNING METHOD APPLICABLE IN SEMICONDUCTOR PROCESSING**

(71) Applicant: Imec VZW, 3001 Leuven (BE)
(72) Inventor: LIU, Mr. Ru-Gun, 302 Hsinchu County (TW); CHANG, Hsinlan, 3000 Leuven (BE); KIM, Ryan Ryoung han, 3020 Veltem-Veisem (BE); LAZZARINO, Frederic, 1320 Hamme-Mille (BE); LIN, Yun-Jing, 3001 Leuven (BE); SHERAZI, Syed Muhammad Yasser, 3360 Lovenjoel (BE)
(74) Representative: Patent Department IMEC

(57) **Abstract**

The method comprises the steps of producing a stack of at least two layers (30,31,32) on a support substrate (25), by lithography and anisotropic etching, producing an opening (33) through said stack of at least two layers, and thereafter applying at least a first directional etching process step, using an etch beam configured to remove the material of one or more upper layers (32) of the stack selectively with respect to the layer or layers (30,31) directly underneath said one or more upper layers, to thereby enlarge the opening in the one or more upper layers (32) while essentially maintaining the in-plane dimensions of the opening in the layer or layers (30,31) directly underneath the one or more upper layers (32). The method can be applied to a stack of several layers which can be enlarged stepwise with respect to further underlying layers of the stack. Directional etching can be done in two opposite directions, possibly applying different etch chemistries in the two directions, to thereby enable the creation of complex three-dimensional structures without requiring expensive multiple lithography steps.

## Description

### Field of the Invention

The present invention is related to semiconductor fabrication processes, in particular to patterning methods applicable for realizing nanometre-sized features in a patterned layer.

### State of the art.

Semiconductor fabrication processing relies on advanced lithography and etch technologies capable of realizing patterns at the nanometre-sized scale required in the front-end-of-line and at the deepest levels of the back-end-of-line process sequences. Realizing 3-dimensional structures such as via connections connected to conductors at two different levels of a multilevel interconnect configuration requires several lithographic exposures, which increases the overall production cost and complexity and increases the probability over overlay-related errors as downscaling advances.

### Summary of the invention

The invention is related to methods in accordance with the appended claims. The method comprises the steps of producing a stack of at least two layers on a support substrate, by lithography and anisotropic etching, producing an opening through said stack of at least two layers, and thereafter applying at least a first directional etching process step, using an etch beam configured to remove the material of one or more upper layers of the stack selectively with respect to the layer or layers directly underneath said one or more upper layers, to thereby enlarge the opening in the one or more upper layers while essentially maintaining the in-plane dimensions of the opening in the layer or layers directly underneath the one or more upper layers. The method can be applied to a stack of several layers which can be enlarged stepwise with respect to further underlying layers of the stack. Directional etching can be done in two opposite directions, possibly applying different etch chemistries in the two directions, to thereby enable the creation of complex three-dimensional structures without requiring expensive multiple lithography steps. The etch selectivity relative to underlying layers can be realized by applying an etch chemistry that is selective to said layers, and/or by adjusting the angle of incidence of the etch beam so that said layers are not irradiated by the beam as a consequence of the shadow effect.

The invention is in particular related to a patterning method applicable in a semiconductor production process, comprising the steps of :
- producing a stack of at least two layers on a support substrate,
- by lithography and anisotropic etching, producing an opening through said stack of at least two layers,
- thereafter applying at least a first directional etching process step, using an etch beam configured to remove the material of one or more upper layers of the stack selectively with respect to the layer or layers directly underneath said one or more upper layers, to thereby enlarge the opening in the one or more upper layers while essentially maintaining the in-plane dimensions of the opening in the layer or layers directly underneath the one or more upper layers.

According to an embodiment, the method further comprises one or more additional directional etching process steps after the first directional etching process step, wherein the opening in respectively one or more subsequent layers underneath the one or more upper layers is enlarged selectively with respect to layers lying directly underneath said one or more subsequent layers.

According to an embodiment, the enlargement of the opening in one or more upper layers and in the one or more subsequent layers is configured so as to obtain a 3-dimensional structure comprising a plurality of steps.

According to an embodiment, in said first or any one of the subsequent directional etching process steps, the etch beam contains an etch chemistry configured to remove the material of said one or more upper layers selectively with respect to the material of the layer or layers directly underneath said one or more upper layers.

According to an embodiment, in said first or any one of the subsequent directional etching process steps, the etch beam is applied at an angle of incidence relative to the stack of layers, configured so that the beam does not impinge on one or more shielded layers of the stack as a consequence of the shadow effect, according to which said shielded layers are shielded from the beam by an edge of the opening through the stack of layers.

According to an embodiment, at least one of the directional etching process steps includes directional etching in two opposite directions, to thereby enlarge the opening in said two opposite directions.

According to an embodiment, in at least one directional etching process step including directional etching in two opposite directions, different etching chemistries are used in the first and second direction.

According to an embodiment, the etch recipe applied in the first direction is configured to enlarge the opening in a single layer and wherein the etch recipe applied in the second direction is configured to enlarge the opening in said single layer and in a layer directly underneath said single layer.

According to an embodiment,:
- the layers of the stack are dielectric layers,
- the opening is a via opening,
- said via opening is enlarged in one or more upper layers so as to form a trench in said one or more upper layers,
- the trench and the via opening are thereafter filled with an electrically conductive material to thereby form a via connection and a conductor.

The invention is also related to a method for designing a standard cell comprising a plurality of gate lines and source/drain contact lines (56), the method comprising the steps of :
- designing the location of via connections for connecting a number of the gate lines and source/drain contact lines to conductors in a metallization level above said gate lines and source/drain lines,
- designing the location and length of said conductors,
characterized in that said designing steps take into account that the via connections and the conductors are to be produced by applying a method according to the invention.

The invention is also related to a lithographic mask for producing via connections for connection to gate lines and source/drain contact lines of a standard cell designed in accordance with the method according to the invention.

The invention is also related to a library of standard cells designed in accordance with a method according to the invention.

### Brief description of the figures

Figure 1 illustrates the main components of a tool suitable for directional etching.
Figures 2a to 2h illustrate a process sequence in accordance with an embodiment of the invention, illustrating how a dual-damascene type 3D structure can be obtained.
Figures 3a to 3f illustrate an embodiment wherein a stepped 3D structure is produced.
Figures 4a to 4c illustrate how an asymmetrical 3D structure can be obtained by a method according to an embodiment of the invention.
Figures 5a to 5e illustrate how a stepped structure can be obtained by a method according to the invention, starting from a stack of alternatingly applied layers of two different materials.
Figures 6a to 6i illustrate more concrete steps of a process sequence including method steps in accordance with an embodiment of the invention.
Figures 7a and 7b illustrate a detail of standard cell design in plane view and in a cross-section.
Figures 8a to 8d illustrate method steps for producing via connections and a conductor of the standard cell design illustrated in Figures 6a and 6b.

### Detailed description of the invention

Directional patterning techniques are being developed as alternatives to the more traditional methods. The term 'directional patterning' encompasses directional etching and directional deposition.

Basic principles and configurations for realizing directional patterning are for example described in patent publication document US10790155. According to the technology, a plasma beam is scanned relative to a substrate comprising a layer that is to be patterned. By tuning several parameters and conditions, it is possible to direct a plasma beam containing etch species so that the beam etches a layer on the wafer at a considerably higher etch rate in the scanning direction than in directions orthogonal to said scanning direction. This capability makes it possible to 'stretch' an existing opening in the layer by scanning a plasma beam across the opening.

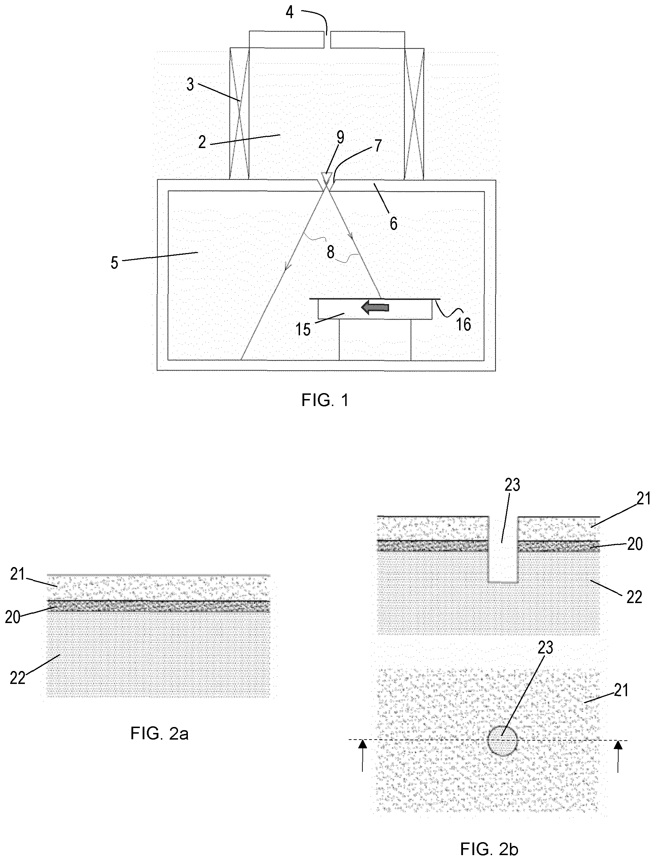

Figure 1 illustrates a process tool 1 for applying one particular directional etching technology that is presently known in the state of the art. The invention is however not limited to this technology. The tool comprises a plasma chamber 2 surrounded by an RF coil 3 for generating a plasma in the chamber. A gas inlet 4 enables supplying a gaseous substance, while the overall pressure in the plasma chamber is kept at very low to vacuum level by a suitable vacuum pump installation (not shown). The plasma chamber 2 is separated from a process chamber 5 by a separating wall 6 comprising a slit 7, so that ribbon plasma beams 8 are emitted from the slit. The process chamber is also at low to vacuum pressure. A meniscus 9 may be mounted in the vicinity of the slit 7 at a distance that can be set in order to control the propagation direction of the emitted beams 8. A wafer stage 15 is mounted in the process chamber 5. The wafer stage 15 is movable linearly as indicated by the arrow, so that a wafer 16 held by the wafer stage can be moved relative to one of the beams 8, thereby creating the equivalent of the beam 8 being scanned across the wafer 16.

As stated, other directional etching technologies are known and can be applied in the method according to the invention. Ion beam-based technologies include a method wherein a collimated beam of charged particles e.g. Ar⁺ is accelerated on a full wafer at a given angle of incidence. In the latter method, the wafer stage is not moving relative to the beam as the beam is impinging on the full wafer. According to another known ion beam-based technology, a collimated beam of ionized gas clusters is accelerated to a spot and scanned across a wafer surface at a given angle of incidence. In the latter two technologies, the angle of incidence of the beam is adjusted by tilting the wafer.

Figures 2a to 2h illustrate a process sequence in accordance with an embodiment of the invention. A stack of layers 20,21 is produced on a support substrate. The substrate may be the process wafer 16 shown in Figure 1, comprising a number of layers on its surface with only the top layer 22 being represented in Figure 2a. For example, the top layer 22 may be a dielectric layer produced in the course of the back end of line (BEOL) fabrication process of integrated circuits on the silicon wafer 16. During said BEOL process, multiple interconnect levels are fabricated, each level comprising horizontal conductors arranged according to a given layout, and further comprising vertical via connections for connecting adjacent levels.

With reference to Figure 2b, a via opening 23 is produced through the layers 20,21 and extending into the layer 22. The opening 23 is produced by standard lithography and anisotropic etch techniques, for obtaining a circular opening having essentially upright sidewalls relative to the planar surface of the top layer 21.

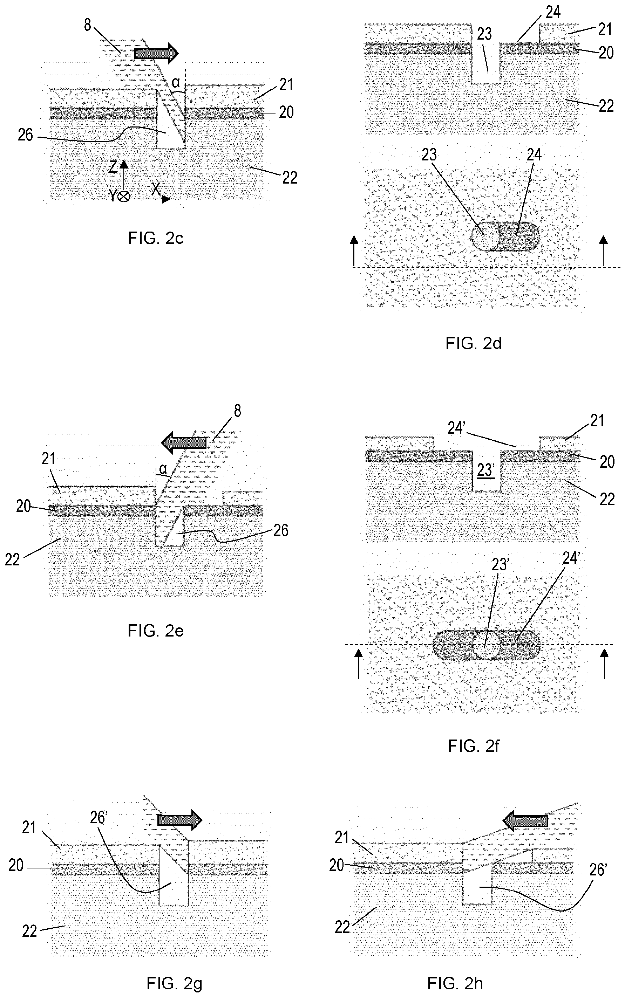

The wafer is then subjected to a directional etch step, by scanning a plasma beam 8 across the opening 23 in a scanning direction X, as illustrated in Figure 2c. In the tool shown in Figure 1, this may be done by moving the wafer stage 15 in the direction of the arrow relative to the stationary beam 8. The beam is oriented at an angle of incidence α relative to the plane of the support substrate, the angle of incidence being defined as the angle between the beam 8 and the direction perpendicular to the surface of the top layer 21. In accordance with the invention, the etch species contained in the plasma beam 8 and the materials of the layers 20,21,22 are chosen such that the top layer 21 is etched selectively with respect to the underlying layers 20 and 22. The effect of the directional etch step is shown in Figure 2d. The opening in the top layer 21 is elongated to form a trench 24 in said top layer, while the opening 23 in layers 20 and 22 remains intact, i.e. the in-plane dimensions (in this case the diameter) of the opening 23 are essentially not affected by the directional etch beam. The directional etch causes thinning of the top layer 21 due to the etch rate of the beam in the Z-direction. The original thickness of the top layer 21 is however chosen so as to take this thinning into account, so that a significant layer thickness remains after the passage of the etch beam. A small etch rate in the Y-direction may cause the trench 24 to be slightly wider than the width of the original opening 23. This effect is however small and not represented in the drawings.

A second directional etch step may be performed as illustrated in Figure 2e, by rotating the wafer 180° and subjecting it again to a linear movement relative to the beam 8, containing the same etch species as applied in the first directional etch step. This results in an elongation of the trench 24 in the top layer 21 in the opposite direction, as illustrated in Figure 2f, and a further thinning of said top layer, while layers 20 and 22 remain essentially unaffected.

In the above described sequence, the etch selectivity with respect to the underlying layers 20 and 22 is realized by the materials of these layers with respect to the etch chemistry of the beam. In other words, layer 21 is etched in the scanning direction but layers 20 and 22 are essentially not etched or etched at a substantially slower rate in said direction even though the beam impinges on these layers, as is visualized in Figures 2c and 2e.

Another way of realizing etch selectivity with respect to underlying layers is by adjusting the angle of incidence of the beam and taking advantage of the so-called shadow effect, according to which the beam does not impinge on areas shielded by the upstream edge of the enlarged opening ('upstream' meaning opposite the propagation direction of the beam). In Figures 2e and 2f, these areas are indicated by numerals 26.

By adjusting the angle of incidence, as illustrated in Figures 2g and 2h, the shielded areas 26' are now including the full height of layer 22 starting from the bottom of the via opening, so that the beam does not impinge on layer 22. Therefore, this layer 22 can be formed of a material that would be etched in the scanning direction if the beam would impinge on the layer, and the etch selectivity for layer 22 (i.e. the fact that the beam does not etch layer 22) is a consequence of the angle of incidence of the beam. The etch selectivity for layer 20 is due to the etch chemistry of the beam relative to the material of this layer, as in the embodiment illustrated by Figures 2e and 2f.

Due to the etch selectivity with respect to the underlying layers 20 and 22 (either due to the material and etch chemistry and/or the angle of incidence), the method thereby enables obtaining a trench 24' with a via opening 23' extending down from the bottom of the trench. This is the type of structure that is produced by the traditional dual damascene technique, where it requires however the application of two lithographic masks and where overlay errors may lead to a misalignment between the via opening and the trench.

By applying the method of the invention, the creation of the via opening 23' and the trench 24' requires a single lithographic mask and the trench is automatically aligned to the via opening.

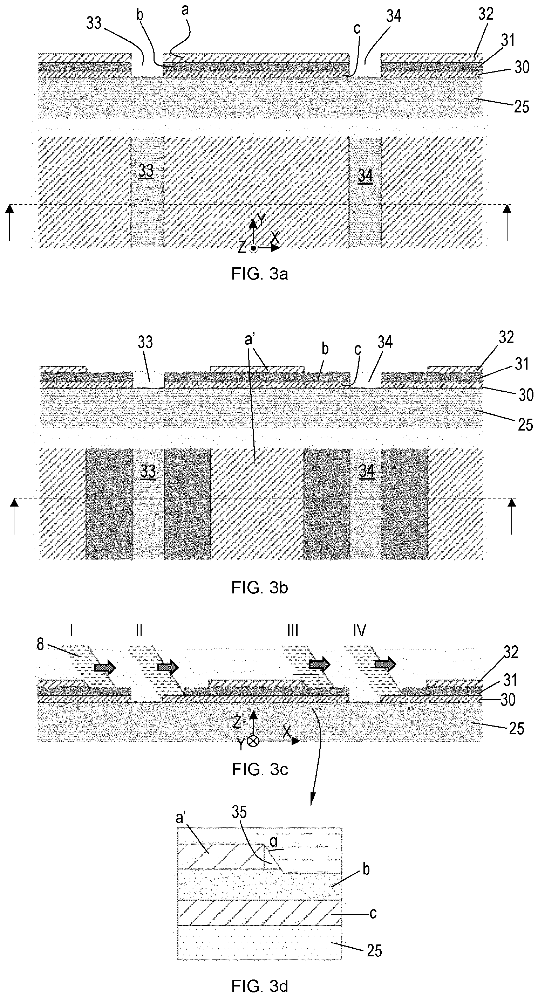

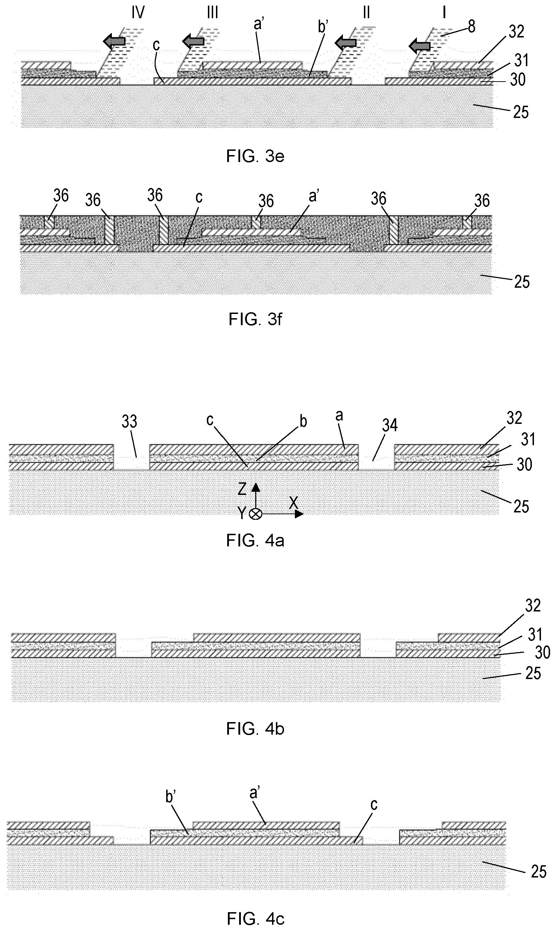

Embodiments of the invention furthermore enable to produce more complex structures, as illustrated in Figures 3 to 5.

In Figure 3a, a stack of three layers 30,31,32 is formed on a support substrate 25. A number of parallel trenches 33,34 is produced by standard lithography and anisotropic etching through the three layers. The trenches 33,34 extend along a distance that may be considerably longer than the width of the trenches. The two trenches 33,34 are separated by layer portions a,b,c of the respective layers 32,31,30. Only two trenches are shown but additional trenches may be formed, preferably at equal distances from each other. In a first sequence of two directional etch steps in opposite scanning directions, respectively in the +X and -X directions, the result of which is illustrated in Figure 3b, the trenches are stretched in the top layer 32, selectively with respect to the underlying layers, to thereby obtain enlarged trenches in the top layer 32. In between the two trenches, the layer portion a has shrunk to a narrower layer portion a' extending the Y-direction.

In a second sequence of two directional etch steps in opposite scanning directions +X and -X, the trenches are stretched in the middle layer 31, selectively with respect to the bottom layer 30 and the top layer 32, to thereby obtain enlarged trenches in the middle layer.

The directional etch steps of the second sequence are illustrated in a little more detail in Figures 3c to 3e. In Figure 3c, four stages I to IV of the scanning movement of the beam 8 are shown, with a magnified detail shown in Figure 3d. This illustrates that the thinning of the middle layer 31 is influenced by the edges of the trenches formed in the top layer 32, as a consequence of the shadow effect : the edges of the top layer are shielding a corner portion 35 of the middle layer from the impinging beam, so that thinning of the middle layer 31 does not occur in this corner portion. The size of the corner portion 35 depends on the angle of incidence α of the beam. The same effect is apparent in the opposite directional etch step, illustrated in Figure 3e. If the etch rate in the Z-direction is small however, this effect may be negligible.

The second sequence of directional etch steps results in the shrinking of the layer portion b of the middle layer 31 in between the trenches, to a narrower layer portion b'. As a result, a symmetrical three-step structure a,b',c' is obtained between each pair of parallel original trenches 33,34.

The stepped structure obtained in this embodiment may be applied in various ways. For example, if the bottom and top layers 30,32 are metal layers and the middle layer 31 is a dielectric layer, the resulting structure comprises longitudinal conductors a' and c extending the Y direction and separated by a dielectric layer. By applying single damascene-type techniques known as such in the art, these conductors can be contacted by via connections 36 as illustrated in Figure 3f.

Figures 4a to 4c illustrate another embodiment, starting from a similar three-layer stack 30-32 as the one shown in the previous embodiment, formed on a support substrate 25, with trenches 33,34 through the layers. As illustrated in Figure 4b, a first directional etch step is performed by scanning an etch beam in the +X direction. As in the previous embodiment, the layer materials and the etch species are chosen such that the trenches in the top layer 32 are enlarged selectively with respect to the underlying layers. In a second directional etch step applied by scanning in the -X direction, a different etch species is applied. This etch species is configured to etch the top layer 32 and the middle layer 31 selectively with respect to the bottom layer 30. The result of the second directional etch step is shown in Figure 4c. The stack of layer portions a',b',c is now asymmetrical.

By increasing the number of layers and applying the same or different etch species in consecutive directional etch steps, the invention thus enables to produce various 3D structures of symmetrical or asymmetrical shape, without requiring complex lithographic exposures through multiple masks.

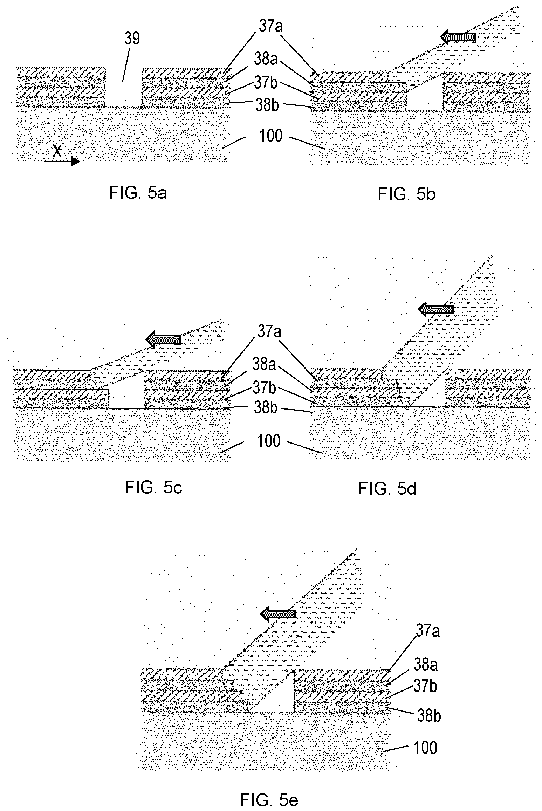

A further example is illustrated in Figures 5a to 5e. Figure 5a illustrates a stack of alternating layers 37a,37b and 38a,38b on a substrate 100. Layers 37a,37b are layers of the same thickness and formed of the same material and layers 38a,38b are layers of the same thickness as layers 37a,37b and formed of the same material that is different from the material of layers 37a,37b. The layer thicknesses of the four layers could also be different from each other.

An opening, for example a trench 39, is formed through the stack, and a number of consecutive directional etch steps are performed in the -X direction, i.e. from right to left on the drawing. It is supposed that the thinning of the layers by the directional etch beam 8 is minimal, and this effect is not represented in the drawings. In the first directional etch step, an etch chemistry is used that etches the material of layers 37a,37b selectively with respect to the material of layers 38a,38b. The angle of incidence of the beam is such that the layer 37b is not irradiated by the beam. The top layer 37a is therefore pushed to the left by the first directional etch step, as shown in Figure 5b.

In a second directional etch step in the same scanning direction, an etch chemistry is used that etches the material of layers 38a,38b selectively with respect to the material of layers 37a,37b, and the angle of incidence is such that layer 38b is not irradiated. The second directional etch step therefore pushes the layer 38a to the left, as shown in Figure 5c. Layers 37a,37b and 38b are not affected.

In a third directional etch step, the first etch chemistry is again used and an angle of incidence is applied so that both layers 37a and 37b are irradiated. Therefore both these layers are pushed to the left, relative to layers 38a,38b as shown in Figure 5d. It is supposed that both etch chemistries enable selective etching relative to the substrate 100 (or to a layer that forms the upper layer of the substrate 100).

In the final directional etch step, the second etch chemistry is again used and an angle of incidence is applied so that both layers 38a and 38b are irradiated. Therefore both these layers are pushed to the left, relative to layers 37a,37b, and relative to the substrate 100, as shown in Figure 5e. A stepped structure is thereby obtained wherein the layers of the two materials are alternatingly pushed to the left relative to the edge of the original opening 39.

The sequence of Figures 5a to 5e can be applied to stacks of more than four layers by repeating the directional etch steps using two different chemistries and adjusted angles of incidence any required number of times. The stepped structure formed of two different materials is applicable for example in the fabrication of flash memory. The invention thereby provides a novel fabrication method of such structures which do not require multiple lithographic masks.

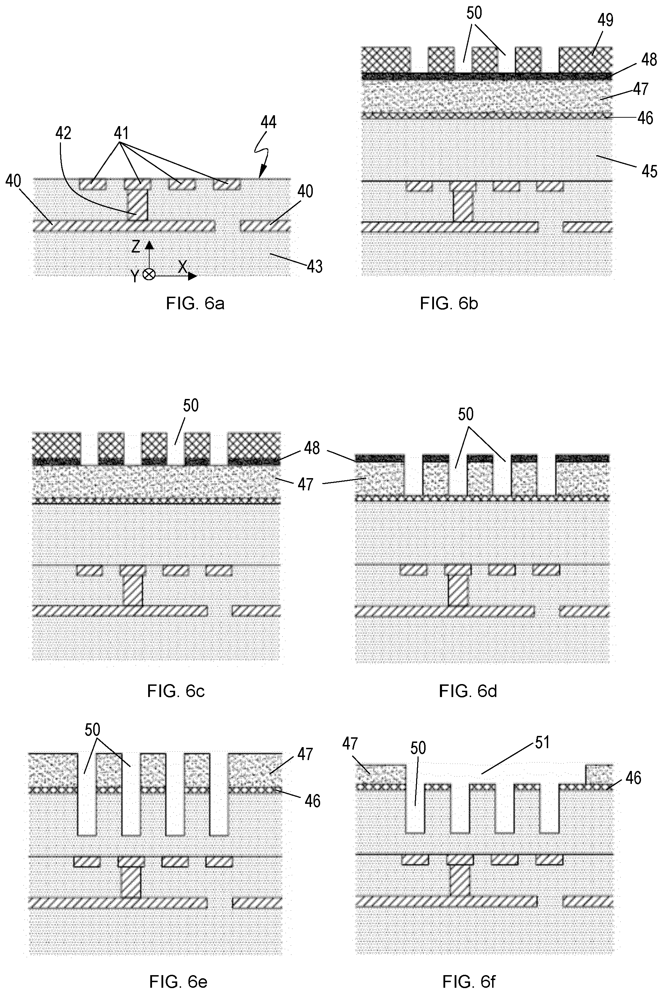

A more concrete example of a process sequence comprising method steps in accordance with the invention is hereafter described, with reference to Figures 6a to 6i. Figure 6a shows a small portion of a multilevel interconnect structure during back-end-of-line processing of integrated circuits on a silicon process wafer. The interconnect structure comprises conductors 40 extending in the X-direction, conductors 41 extending in the Y-direction, and via connections 42 extending in the Z-direction. The conductors are embedded in dielectric material 43, which may be SiO₂ or any other material suitable as IDL material (Inter Layer Dielectric) in a BEOL stack. An additional interconnect level is to be produced on the planarized SiO₂ surface 44.

With reference to Figure 6b, a stack of layers is first produced on said planarized SiO₂ surface 44. A non-limiting example of applicable materials and layer thicknesses is given hereafter. These materials and layer thicknesses are applicable at the deepest levels of the BEOL stack, for producing via connections and conductors at nanometre-scale. First a further SiO₂ layer 45 is produced of about 100 nm thick. On top of the SiO₂ layer, the following layers are produced (thicknesses are indicated between brackets) : a layer 46 of TiN (15 nm), a layer 47 of amorphous carbon (60nm) hereafter abbreviated as aC layer, a layer 48 of SiOC (15nm), a resist layer 49 (30nm). The resist layer is patterned by lithographic exposure and stripping of non-developed resist, according to a pattern comprising a number of via openings 50 spaced apart at regular intervals. The diameter of the openings 50 is about 20 nm and the center-to-center pitch of the openings is about 45 nm.

With reference to Figure 6c, the pattern of via openings 50 is transferred by etching from the resist layer to the SiOC layer 48. Thereafter, with reference to Figure 6d, the openings are further transferred to the amorphous carbon layer 47, by an etch recipe that also removes the resist 49. By additional etch recipes, the openings 50 are transferred to the TiN layer 46 and into the SiO₂ layer 45. One of these etch recipes removes the SiOC layer, leading to the condition shown in Figure 6e : via openings 50 are etched through the stack of layers 46,47.

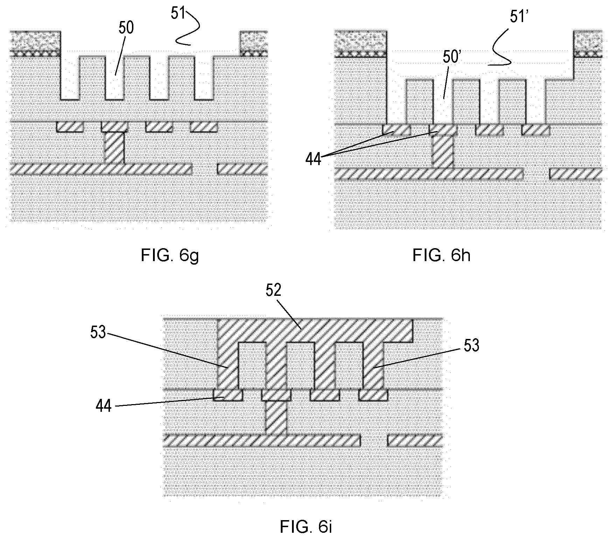

At this point, directional etching is applied by scanning an etch beam in the +X direction, using an etch species that etches amorphous carbon selectively with respect to TiN. The result is shown in Figure 6f. In accordance with the invention, the via openings are enlarged in the aC layer only, and merge to form an elongate trench 51 in said aC layer, thereby defining a hardmask in the aC layer 47. By a further etch recipe, the TiN 46 is removed from the bottom of the trench 51 with respect to the aC hardmask (Figure 6g). Thereafter (Figure 6h), the SiO₂ is etched relative to the aC hardmask 47, to thereby deepen the trench 51' and the via openings 50', until the bottom of the latter reaches the conductors 44.

With reference to Figure 6i, the via openings 50' and the trench 51' are thereafter filled with metal to thereby obtain a conductor 52 oriented in the X-direction and via connections 53 oriented in the Z-direction. The upper surface of the SiO₂ layer 45 is then planarized and a further BEOL level can be processed thereon in the same way as described above.

The above-described embodiments are applicable regardless of the directional etch technology that is being used. When applying a collimated beam that impinges on a full wafer, the beam is not scanned as indicated by the arrows in the drawings, but the effect of the beam is the same. Changing the angle of incidence can be done by tilting the wafer. When applying a collimated beam of ionized gas clusters on a spot of the wafer, the beam may be scanned as illustrated in the drawings, while the angle adjustment is also done by tilting the wafer.

The method of the invention can be applied in the fabrication of standard cells by taking advantage of the location of via connections which connect the gate lines and source/drain contact lines associated to transistors in the front end of line part of an integrated circuit, to the next metallization level. By producing via openings to the gate and S/D contact lines through a stack of layers and elongating one or more upper layers by directional etching relative to the underlying layers, trenches are formed which are self-aligned to the via openings. Elongation can be realized by directional etching in one direction or in two opposite directions as illustrated in Figures 2a to 2f. The via connections and the conductors of the next metallization level are thereafter formed by filling the trenches with an electrically conductive material. An example is given hereafter.

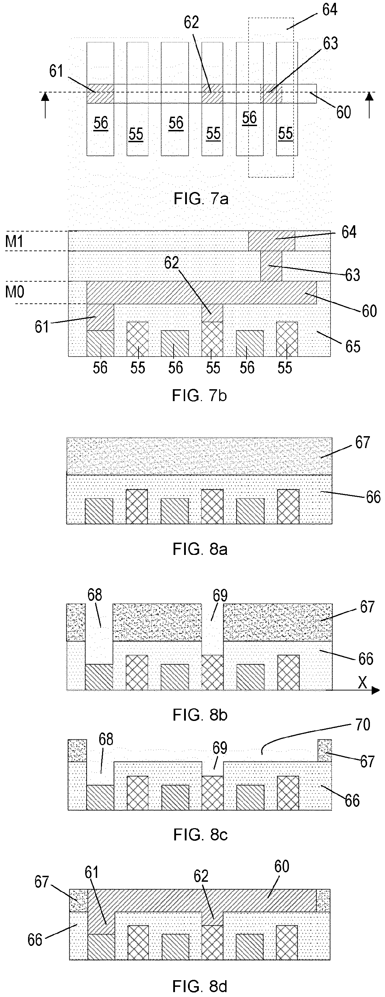

A small detail of a possible standard cell layout is shown in Figures 7a and 7b, showing respectively the in-plane layout and a cross-section. Gate lines 55 and S/D contact lines 56 are alternatingly arranged at the same level. One of the gate lines is to be connected to a S/D line 56 through a conductor 60 in the next level referred to as the M0 level in this example. The connection is to be made by via connections 61 and 62 respectively reaching down to the gate line 55 and to the S/D line 56. The M0 conductor 60 is itself connected by a further via connection 63 to a conductor 64 in the next level, here referred to as the M1 level. The conductors and vias are embedded in dielectric material 65.

Method steps for producing the M0 conductor 60 and the vias 61 and 62 in accordance with an embodiment of the invention are illustrated in Figures 8a to 8d. The gate lines and S/D lines are embedded in a first dielectric layer 66 planarized at a first level. A second dielectric layer 67 formed of a material different from the material of layer 66 is then applied on the first dielectric layer.

Via openings 68 and 69 are produced at the desired locations through the stack of layers 66/67, as indicated in Figure 8b. A directional etch beam is then scanned across the openings in the +X-direction, wherein the etch chemistry etches the top dielectric layer 67 selectively with respect to the underlying layer 66, so that the via openings are stretched only in the top layer 67, as illustrated in Figure 8c. The top layer 67 is thinned after the passage of the directional etch beam. The elongation is such that the elongated vias merge to form a trench 70 of the desired length for producing the M0 conductor, by filling the trench and the via openings, as illustrated in Figure 8d. In order to obtain a desired height of the M0 conductor 60, the layer thickness of layer 67 has to be chosen so as to take into account the thinning of layer 67 by the directional etch beam.

The above sequence results in a structure comprising two different dielectric materials embedding respectively the via connections 61,62 and the conductor 60. For obtaining a structure wherein the via connections and the conductor are embedded in the same material, the sequence described with reference to Figures 6a to 6i can be applied, wherein the directional etch step is applied to a mask layer, followed by transferring the mask pattern to a dielectric layer. Both sequences are applications of the present invention in the sense that a via is formed through a stack of layers, followed by directional etching of an upper layer selectively with respect to an underlying layer.

The invention is thus related to methods for designing a standard cell in terms of the location of via connections and the location and length of conductors connected to said via connections in a next metallization level. According to said methods, locations of via connections to gate lines and S/D lines, and length and location of M0 conductors are designed so that predefined M0 conductors can be produced starting from the location of the vias, taking into account the obtainable elongation through the directional etching process. The design of the standard cell takes into account a specific directional etch process in terms of the layer stack into which the via openings are produced and the etch species and other directional etch-related parameters applied in elongating one or more upper layers starting from said via openings.

The invention is related also to methods for producing a lithographic mask for the production of the via connections for connection to gate lines and S/D lines of a standard cell designed according to the invention. The invention is also related to a library of standard cells designed according to the invention.

## Claims

1. A patterning method applicable in a semiconductor production process, comprising the steps of :
- producing a stack of at least two layers (30,31,32) on a support substrate (25),
- by lithography and anisotropic etching, producing an opening (33) through said stack of at least two layers,
- thereafter applying at least a first directional etching process step, using an etch beam (8) configured to remove the material of one or more upper layers (32) of the stack selectively with respect to the layer or layers (30,31) directly underneath said one or more upper layers, to thereby enlarge the opening in the one or more upper layers (32) while essentially maintaining the in-plane dimensions of the opening in the layer or layers (30,31) directly underneath the one or more upper layers (32).

2. The method according to claim 1, further comprising one or more additional directional etching process steps after the first directional etching process step, wherein the opening in respectively one or more subsequent layers (31) underneath the one or more upper layers is enlarged selectively with respect to layers (30) lying directly underneath said one or more subsequent layers.

3. The method according to claim 2, wherein the enlargement of the opening in one or more upper layers (32) and in the one or more subsequent layers (31) is configured so as to obtain a 3-dimensional structure (a',b',c) comprising a plurality of steps.

4. The method according to any one of the preceding claims, wherein in said first or any one of the subsequent directional etching process steps, the etch beam contains an etch chemistry configured to remove the material of said one or more upper layers selectively with respect to the material of the layer or layers directly underneath said one or more upper layers.

5. The method according to any one of the preceding claims, wherein in said first or any one of the subsequent directional etching process steps, the etch beam (8) is applied at an angle of incidence relative to the stack of layers, configured so that the beam does not impinge on one or more shielded layers of the stack as a consequence of the shadow effect, according to which said shielded layers are shielded from the beam by an edge of the opening (23) through the stack of layers.

6. The method according to any one of the preceding claims, wherein at least one of the directional etching process steps includes directional etching in two opposite directions, to thereby enlarge the opening (33) in said two opposite directions.

7. The method according to claim 6, wherein in at least one directional etching process step including directional etching in two opposite directions, different etching chemistries are used in the first and second direction.

8. The method according to claim 7, wherein the etch recipe applied in the first direction is configured to enlarge the opening in a single layer (32) and wherein the etch recipe applied in the second direction is configured to enlarge the opening in said single layer (32) and in a layer (31) directly underneath said single layer.

9. The method according to any one of the preceding claims, wherein :
- the layers (20,21;45,46,47) of the stack are dielectric layers,
- the opening (23,50') is a via opening,
- said via opening is enlarged in one or more upper layers (21;47) so as to form a trench (24',51) in said one or more upper layers,
- the trench and the via opening are thereafter filled with an electrically conductive material to thereby form a via connection (53) and a conductor (52).

10. A method for designing a standard cell comprising a plurality of gate lines (55) and source/drain contact lines (56), the method comprising the steps of :
- designing the location of via connections (61,62) for connecting a number of the gate lines and source/drain contact lines to conductors (60) in a metallization level above said gate lines and source/drain lines,
- designing the location and length of said conductors (60),
**characterized in that** said designing steps take into account that the via connections (61,62) and the conductors (60) are to be produced by applying a method according to claim 9, wherein the conductors (60) are produced starting from via openings through a stack of layers, at the location of the via connections, taking into account an obtainable elongation in one or more upper layers of the stack, through a directional etching process.

11. A lithographic mask for producing via connections (61,62) for connection to gate lines (55) and source/drain contact lines (56) of a standard cell designed in accordance with the method according to claim 10.

12. A library of standard cells designed in accordance with a method according to claim 10.
